# EUROPEAN PATENT SPECIFICATION

(11) **EP 0 132 279 B1**
(45) Date of publication and mention of the grant of the patent: **22.06.1994**
(21) Application number: 83903308.1
(22) Date of filing: 26.10.1983
(51) Int. Cl.: H02N 6/00

(54) **COMPOSITE ELECTROMOTIVE APPARATUS UTILIZING SOLAR ENERGY AND THE LIKE**
KOMPOSIT-ELECTROMOTORISCHE VORRICHTUNG UND VERWENDUNG VON SONNENENERGIE UND ÄHNLICHEM
APPAREIL ELECTROMOTEUR COMPOSITE UTILISANT L'ENERGIE SOLAIRE ET ANALOGUE

(30) Priority: 28.12.1982 JP 229846/82
(43) Date of publication of application: 30.01.1985
(73) Proprietor: NAGAI, Toki, Tokyo 150 (JP)
(72) Inventor: NAGAI, Toki, Tokyo 150 (JP)
(74) Representative: Freed, Arthur Woolf
(86) International application number: PCT/JP83/00379
(87) International publication number: WO 84/02584

(56) References cited:
- DE-A- 2 412 908
- DE-A- 2 460 075
- DE-A- 2 604 175
- DE-A- 2 713 555
- FR-A- 1 296 568
- FR-A- 2 272 520
- JP-A- 5 124 433
- JP-A-56 126 988
- JP-U-57 195 391
- US-A- 4 002 031
- US-A- 4 002 032

## Description

### TECHNOLOGICAL FIELD

This invention relates to a solar energy converter for producing electricity.

### TECHNOLOGICAL BACKGROUND

Devices have been proposed which use solar energy or other natural phenomena, for example wind, to generate electricity.

German patent Nos DE-A-2 412 908 (Schatta) and DE-A-2 460 075 (Schatta) describe apparatus for generating electricity using wind power.

French patent No. 1 296 568 describes an apparatus for generating electricity for solar power using both photo and thermal energy.

German patent No. DE A-2-604 175 (Thalheim) is another document which discusses the production of electricity from primarily wind power. Usually, electric generators consist of a single element system, e.g., in a hydroelectric generator system the flow of water is used to generate power. In another system, for example, a thermoelectric steam power plant system, there may be some problems involved in the generation of electricity. For example huge intermediate functional facilities, such as turbines and the like give rise to losses in the energy conversion.

Wind power plant systems are disadvantageous in that there may be difficulties in stabilization due to the unstable, regional and/or climatic conditions which leads to inefficiency.

Nuclear power plants pose difficulties relating to the leakage of radioactivity in spite of claims that such plants are safe.

In conventional systems where solar energy is utilized to produce electrical energy, there may be great losses due to the use of turbines etc. In addition the efficient conversion of the solar energy has proved to be difficult.

Moreover, conventional generators and/or elec- tromotivators can take up large areas and/or involve the shifting of a great deal of resources, that is several changes in the form of energy may be involved.

This invention aims to provide a solar energy converter which requires less space, and involves fewer transfers of energy. It is also an aim of the invention to provide an apparatus which is suitable for portable use, is constructed as a single-body, or in the form of an array of individual converters.

### SUMMARY OF THE INVENTION

According to the present invention, there is provided a solar energy converter comprising; at least one lens housed in a container for receiving sunlight and focusing the sunlight at a focal point of the lens, whereby the lens acts as a heat-collecting condenser; and at least one thermocouple(s) of which the high-temperature side(s) is/are positioned adjacent to the focal point of the lens and face(s) upwardly towards the lens, characterised in that a spacer is provided in the container for supporting the thermocouple and dividing the container into high and low temperature regions on respective sides of the thermocouple, the space between the lens and the thermocouple defining the high temperature region of the apparatus, and the thermocouple(s) acting so as to convert some of the sunlight into electrical energy; a photovoltaic cell disposed oppositely in the container with respect to the lens for receiving the sunlight diverging from the focal point and converting the sunlight into electric power, the space between the photovoltaic cell and the thermocouple(s) defining the low temperature region of the apparatus; a fan means configured so as to be driven by both convective air rising from the photovoltaic cell and direct radiation received by the fan, the fan means offering resistance to convective heat rising from the photovoltaic cell thereby assisting, in conjunction with the spacer, the maintenance of a relatively high temperature differential across the thermocouple(s), the convective air also flowing across the side of the thermocouple facing the low temperature region for removing heat therefrom and helping to maintain a temperature differential across the thermocouple; and an electromagnetic generator, driven by the rotation of the fan means, for converting some of the convective heat energy into electric power, the lens, the thermocouple, the photovoltaic cell and the fan means thereby combining so as to enhance conversion of solar energy into electrical energy.

With the above, by means of the mutually cooperating effects of the lens, thermocouple, low and high temperature regions, converted currents, photovoltaic cell and fan means, an enhancement in the production of electrical energy from solar energy is achieved, without wasting hugh spaces or the need for complicated related-facilities.

### BRIEF DESCRIPTION OF THE DRAWINGS

The invention will now be further described by way of example, with reference to the accompanying drawings, in which:

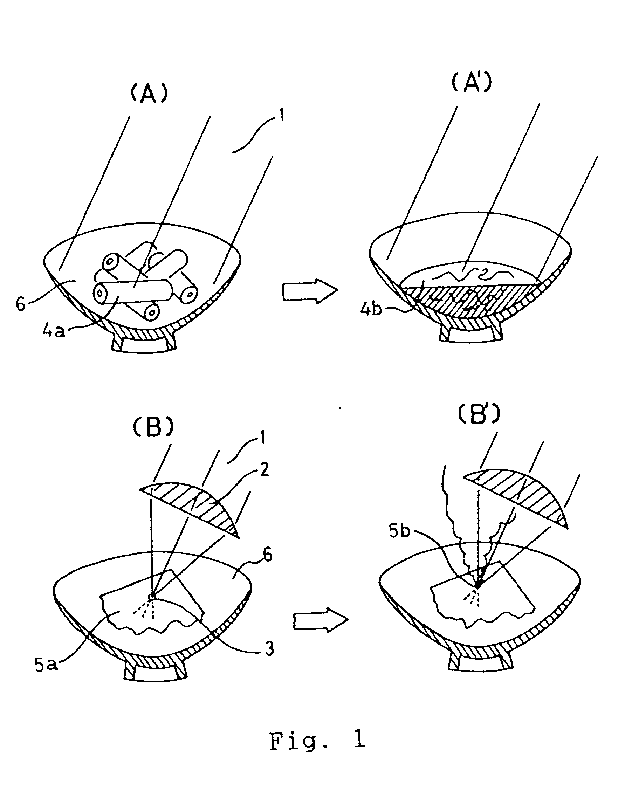

Figure 1 illustrates the physical principles utilised in the conversion of solar energy into electrical energy in embodiments of the present invention;
Figure 2a shows a switching circuit for coupling a thermocouple to a battery or to a thermal indicator device;
Figure 2b shows a pair of thermocouples converted to a battery and thermal indicator device respectively;
Figure 3 shows an illustration of an embodiment of this invention;
Figure 4 shows a detailed schematic and isometric drawing of a generator portion of the embodiment of Figure 3;
Figure 5 shows an illustration of another embodiment of the present invention;
Figure 6a shows a fan means for use in an embodiment of the invention;
Figure 6b is a portial sectional view of a core of the fan means of Figure 6a; and
Figure 6c illustrates electrical connections for the fan means of Figures 6a and b.

### DETAILED DESCRIPTION OF THE DRAWINGS

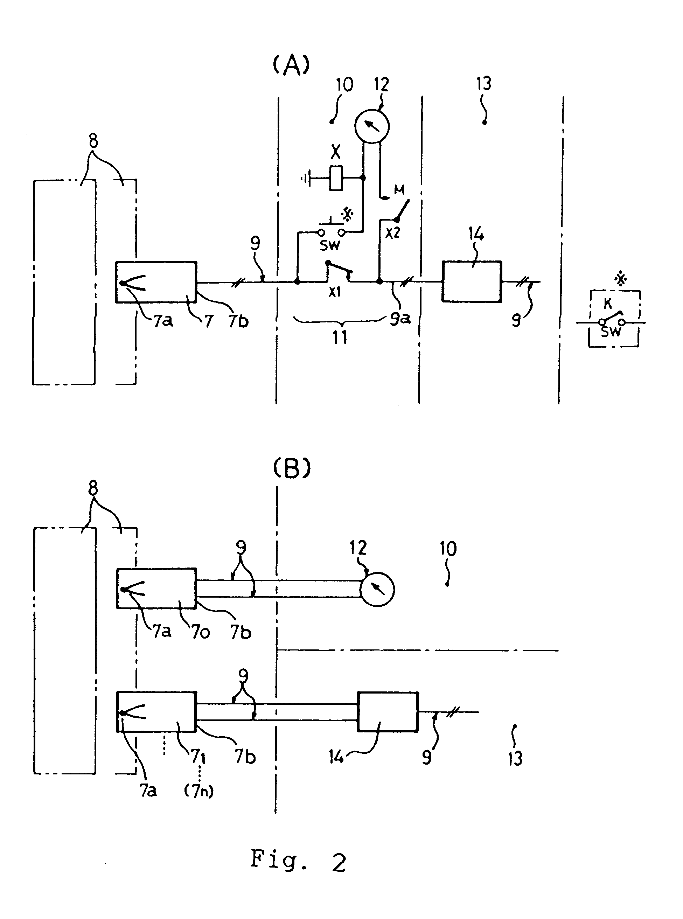

Figure 2a shows how a thermocouple 7 for use in embodiments of the invention can be switched between a battery 14 and a thermal indicator device 12 by a switching circuit 11. The thermocouple 7 can be coupled to the thermal indicator device 12 for indicating the temperature difference across the thermocouple 7. During other times, the thermocouple is coupled to the battery 14 therby contributing to the generation and storage of electric power. Figure 2b shows an alternative arrangement where one of a plurality of thermocouples 7₀.....7ₙ is permanently coupled to the therrmal indicator device 12 and another thermocouple 7, is permanently coupled to the battery 14.

The battery equipment 14 includes charging, accumulating and discharging equipment for storing electrical energy in response to the electromotive force produced across the thermocouples 7₀.....7_{"}.

In embodiments of the invention, the thermocouples 7₀.....7ₙ are selected and formed from materials which suit the ambient conditions and operating parameters.

A number of possible thermocouple-thermometers which are actually fit for high temperature measuring, are described in 'DENKI KOJI HIKKEI' (electric work handbook) edition supervised by HASUI, Takao, issued by SANSEIDO Co., Ltd., February 25, 1978, 3rd Edition. This edition includes tables indicating the E.M.F. generated by various thermocouples according to their composition and according to the temperature difference across them.

In Figure 2a, the single thermocouple (thermometer) 7, has its high temperature side 7a directed to the incoming light. The switching circuit 11 is inserted in a serial circuit from the low temperature side 7b of the thermocouple 7 and is connected thereto by a lead wire passing through a waterproof plug attached to the back of the thermocouple at the cold junction. The switch 11 includes a transiently operable switch SW (that is the switch is on only when pushed, and OFF when the operator's hand is released) which, in one position triggers the relay X so as to make the relay _{X1} contact, and to make the relay x₂ break. In another position the relay _{X1} opens and the relay x₂ closes thereby switching on the thermal indicator 12. If necessary, the switch SW may be operated via a solenoid key K, which may be controlled by a timer. The thermal indicator 12 is housed within a control centre room (instrument room). The measurement may be recorded if necessary. The battery equipment 14 is housed in an electricity room 13 (converter/transformer room etc.) and operates, to gain accumulation of the motivated electricity by virtue of the electromotive force provided by the thermocouple(s) 7.

In Figure 2b. the thermocouple-thermometers 7₀, 7₁ (......n) are set towards or at a heat source thermal substance 8. For the purpose of temperature measuring, the circuit is to be connected to the thermal indicator 12, and for the purpose of providing electrical energy, the thermocouples 7₁ to 7ₙ are connected to the battery equipment 14. The lead wires 9 extend from their lead wire extraction hole (low-temperature part) side 7b.

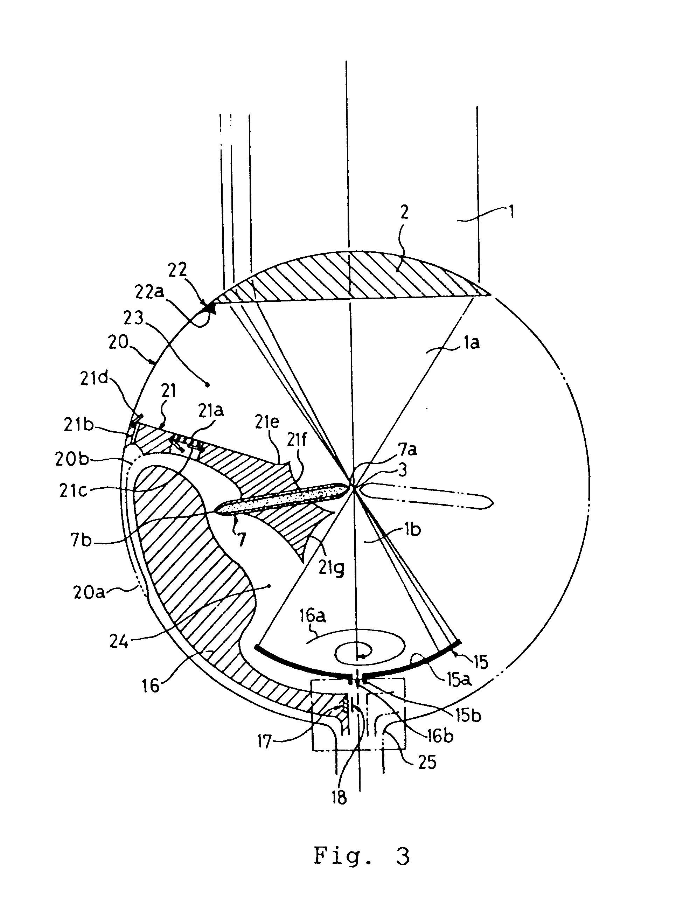

Figure 3 illustrates a vertical section through an embodiment of this invention. The embodiment comprises a mostly transparent and global vessel or container 20 (which is as far as possible constructed to be heat-resisting and fireproof, explosionproof, windproof, waterproof, and semi-airtight). The container 20 contains a convex lens 2 as a heat-collecting condenser, and openings 20a (which act as vents or capillary/channels and filters). Adjacent to the focal point 3 of the lens 2, at the centre of the vessel 20, the high-temperature side/thermoposition(s) 7a is/are positioned facing towards the lens 2. A spacer 21 is positioned for dividing the container 20 into high and low-temperature regions 23, 24 respectively. The spacer 21 also serves to support the thermocouple 7.

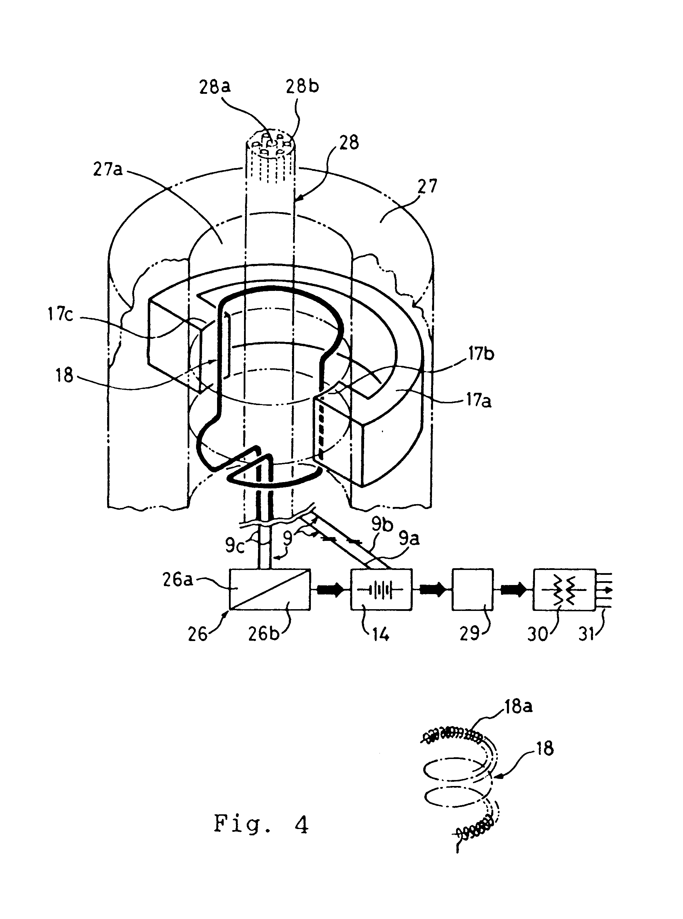

A photovoltaic cell 15, accepts sunlight etc. as diffused rays after being converged 1 a by the lens 2. The rays then diverge 1 before striking the surface of the photovoltaic cell 15a. A cooling fan 16, utilizing convention currents of warm air rising from the photovoltaic cell 15 acts for maintaining the low-temperature part side 7b of the thermocouple and for cooling the photovoltaic cell surface 15a. The fan 16 is associated with a magnet 17 and includes a coil 18. Relative rotation between the coil 18 and the magnet 17 (by virtue of rotation of the fan 16) generates some electricity which contributes to the overall conversion of solar energy to electrical energy. The generator, provided by the coil 18 and magnet 17 is described in more detail with reference to Figure 4. The fan 16 directs warm convective air down a venting route 16b and through lead wire path(s) 28a (see Figure 3).

The solar energy converter of Figure 3 operates as follows: sunlight (etc.) 1 is collected and condensed by means of the lens 2 thereby adding to a light collecting effect resulting from the spherical and transparent container 20 itself. The condensed solar rays are focused at the lens focal point 3 positioned at the globe centre of the apparatus. The diffused rays of sunlight give rise to a temperature difference across the thermocouple 7. The thermocouple may comprise a disk 7 which is a compound of thermocouples. The high-temperature side of the thermocouple are positioned adjacent to the lens focal point 3. A temperature differential between the high-temperature part side 7a and the low-temperature part side (the circumference part side of the thermocouple elements disk) 7b gives rise to an electromotive force which contributes to the production of an electric current which in turn charges the battery 14.

The thermocouple's Peltier effect, contributes to the efficiency of the apparatus. The Peltier effect arises from motivated electric current being charged on the thermocouple line element.

The photovoltaic cell receives the sunlight 1 after divergence 1 b. The surface 15a may be in the form of photovoltaic elements shaped into a bowl, cup or other shaped surface e.g. the surface may be such as to have a focal point coincident with the focal point 3 in order to improve the efficiency of the photovoltaic cell.

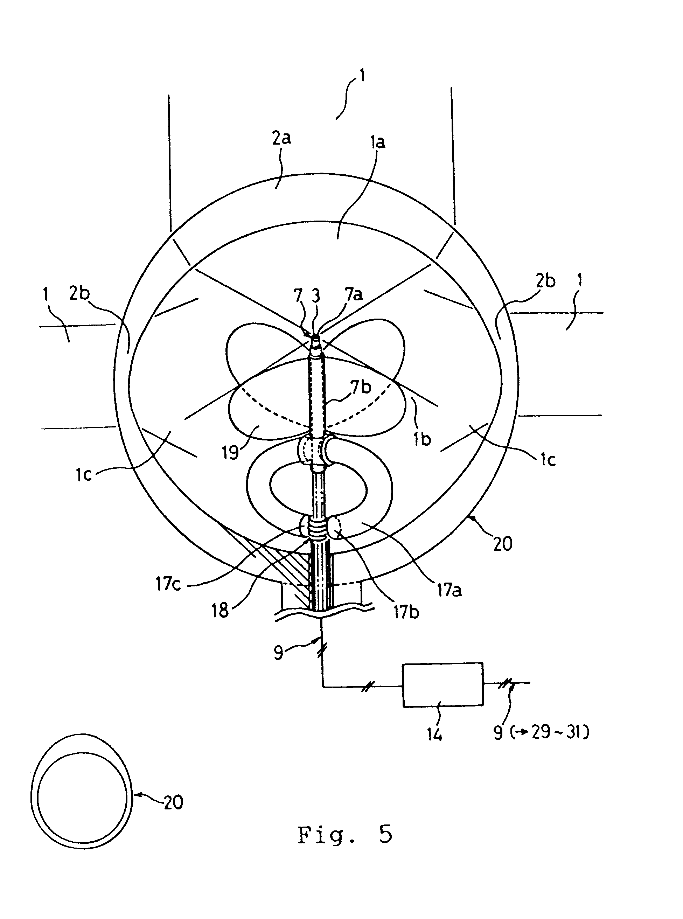

The use of convection by means of the cooling fan 16 enables heat removal to raise the photovoltaic action and effect of the photovoltaic cell 15a. The heat removal enhances the temperature differentiation effect at the thermocouple low-temperature part side 7b. With rotation of the fan 16, warm air 16b heated by virture of the solar energy striking the photovoltaic cell 15 moves towards and into a neck vent 15b, thereby removing heat from the photovoltaic cell. The spacer 21 divides, together with the thermocouple elements disk 7, the vessel 20 into a high-temperature side 23 and low-temperature side 24. The spacer supports the thermocouple elements disk 7 and is available for supporting lead wires. The spacer 21 is supported by the vessel 20 (which may be semi-transparent to opeque at the bottom). The vessel 20 has pores which act as vents, capillary/channel and filters (outside opening and inside opening) 20a, 20b. The spacer 21 also has air adjusting openings with filters, (from warm to cool) 21 a and (from cool to warm) 21 b, and air adjusting valves, (from warm to cool) 21 c and (from cool to warm) 21 d, for promoting or aiding the fan's 16 rotation through convection etc. caused by temperature differentiation. In addition to the above, the spacer 21 is designed to have a cool air current controlling rim 21e, high-temperature reflecting and holding wall surface 21f, cool vent protecting/controlling wall surface 22. These are convection controlling wall surfaces to promote the convection's directionality, including those around the lens fixture 22. with the convection controlling rim surface. (except in the case where the lens is unified with the apparatus vessel see Figure 5). All the above assist the convection within the vessel 20, moreover, the spacer 21 is helpful for protecting and holding the temperature differential between the low-temperature part side 7a and the high-temperature part side 7b of the thermocouple 7.

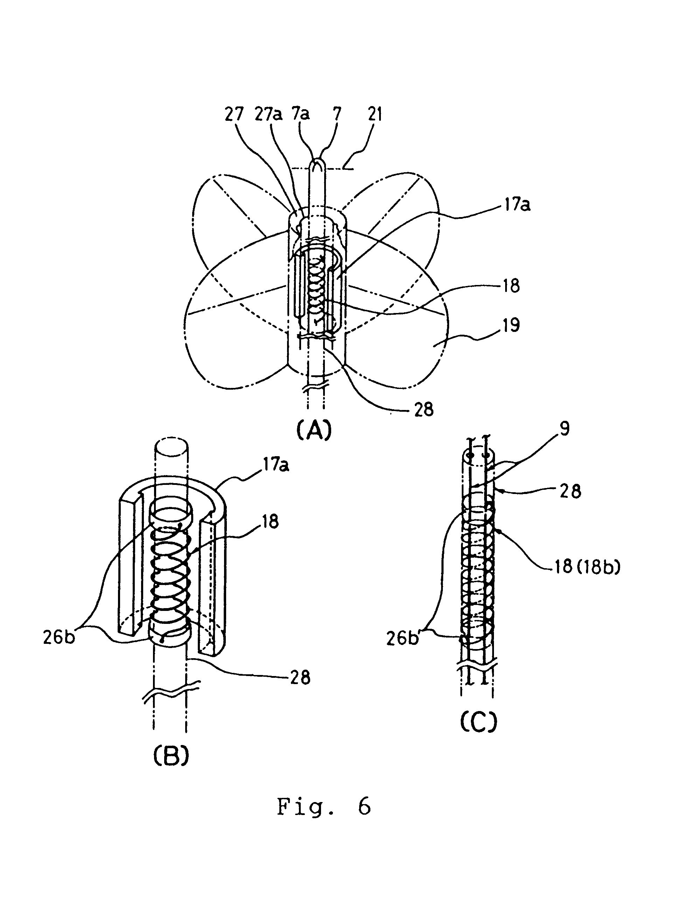

What is shown in Figure 4 is a detailed schematic and isometric drawing of an electrical generator of this embodiment of Figure 3, and includes a brief block diagram of the connecting devices, circuits, and the generator. The generator can be incorporated into the embodiments of Figures 5 and 6. The generator comprises a frame 27, which is positioned in the nect 25 of the vessel 20. In or on a surface of the frame inner wall 27a of the fan neck 25, a permanent magnet 17a with magnetic poles, N and S, 17b and 17c is provided. The ringshaped frame inner wall 27a encircles an element of coil 18. The drawing only schematically expresses the coil 18 with one turn although in actuality, a greater number of turns is provided. The coil 18 portion crosses the magnetic flux of the magnets 17. An illustration of a multi-coil type construction is provided in the inset of Figure 4. This multi-coil is made of a coiled conductor, that is, a coiled coil. The axis of the coil 18 includes a conductive insulating tube which contains the current lead wire path 28b. This path is a general lead wire route and includes wires from the thermocouple elements disk 7 and the photovoltaic cell 15. Ventilation circuits may be constructed, according to necessities, enabling provision of automatic control of switching valves by air pressure.

Generated electric current is fed to the battery 14 via lead wires 9 and slip rings 26a. The current then passes to circuits 29, 30, 31 for transforming and delivering the current to the supply.

In addition to the above basic operation and effects of the composite electrical power generation some of the ventilation or air current may be sent, via the route 28, drive remote and/or indirect facilities.

Figure 5 shows an illustration of another embodiment of this invention.

A container or vessel 20 (heat resistant, fireproof, explosionproof, windproof and waterproof) is a transparent sealed vessel, has a convex lens 2a and a concave lens 2b formed in the faces of the vessel. The vessel 20 may be egg-shaped externally and spherical or global internally. At the focal point 3 of the convex lens, the high-temperature part of the thermocouple 7a is positioned. A rotation axis passes through the low-temperature part 7b. A photo-accepter fan 19 is connected or interlocked with the permanent magnet 17a and rotates together with the magnet. Between the poles, 17a, b there is a coil 18. When solar energy or the like is incident at the focal point 3, of the convex lens portion 2a, the thermocouple 7a operates. Diffused rays of sunlight, after convergence 1 a, diverge 1 b and are accepted by the radiation photo-accepter fan rotor 19. The incidence of radiation on the fan rotor 19 causes rotation of the rotor which is enhanced by divergent radiation 1 from the concave lens 2b. At the same time, the rotation of the photo-accepter fan rotor 19 drives the generator. The generator has the permanent magnet 17a which is connected to the fan rotor 19 and the coil 18 is set between the poles 17b, 17c of the permanent magnet. The photo-accepting rate of the fan rotor of the photovoltaic unit is higher owing to the transparent and sealed apparatus vessel 20 with convex and concave lens portions, 2a, 2b.

The photo-accepter fan rotor 19 performs both functions as a photo-accepter and a fan and also functions as a radiator, and so this can be designed in single and simplified mode construction.

In addition to the above, as for the use of this radiator photo-accepter fan rotor 19, its cooling and heat-removal function concerns holding and strengthening the temperature differentiation between the thermocouple 7 high-temperature part side 7a and its low-temperature part side 7b, and so, it is also effective for the conversion of solar energy to electric power.

Fig. 6 shows another arrangement of a photo-accepter fan rotator/rotor. The generator is constructed as follows: (A) shows an assembly of the photo-accepter fan and generator 18; (B) is a detailed drawing of the fan rotor core; (C) is a representation how lead wires pass inside the insulating tube.

In Figs. 6a and 6b, the magnet is coupled to the fan rotor 19 so that when the rotor 19 rotates, relative motion exists between the coil 18 and the magnet 17. This relative motion results in the generation of electric power.

The above-mentioned one composite body does not take up so much space which is usually necessary, and makes best use of such limits as space, time, weather, environment. Embodiments may be designed not only for a body in a fixed installation, but also for an attachment to a moving body.

## Claims

1. A solar energy converter comprising; at least one lens (2) housed in a container (20) for receiving sunlight and focusing the sunlight at a focal point (3) of the lens, whereby the lens acts as a heat-collecting condenser; and at least one thermocouple(s) (7) of which the high-temperature side(s) (7a) is/are positioned adjacent to the focal point (3) of the lens (2) and face(s) upwardly towards the lens (2), characterised in that a spacer (21) is provided in the container for supporting the thermocouple (7) and dividing the container into high and low temperature regions on respective sides of the thermocouple, the space between the lens and the thermocouple (7) defining the high temperature region of the apparatus, and the thermocouple(s) (7) acting so as to convert some of the sunlight into electrical energy; a photovoltaic cell (15) (15a) disposed oppositely in the container with respect to the lens (2) for receiving the sunlight diverging from the focal point (3) and converting the sunlight into electric power, the space between the photovoltaic cell (15) and the thermocouple(s) (7) defining the low temperature region of the apparatus; a fan means (16a) configured so as to be driven by both convective air rising from the photovoltaic cell (15) and direct radiation received by the fan, the fan means offering resistance to convective heat rising from the photovoltaic cell thereby assisting, in conjunction with the spacer (21), the maintenance of a relatively high temperature differential across the thermocouple(s), the convective air also flowing across the side of the thermocouple (7) facing the low temperature region for removing heat therefrom and helping to maintain a temperature differential across the thermocouple (7); and an electromagnetic generator (17), driven by the rotation of the fan means (16a), for converting some of the convective heat energy into electric power, the lens, the thermocouple, the photovoltaic cell and the fan means thereby combining so as to enhance conversion of solar energy into electrical energy.

2. A converter according to claim 1, the lens (2) being situated at the uppermost portion of the housing, the photovoltaic cell (15) being situated at the lower end of the housing remote from the solar energy source, the thermocouple(s) (7) being situated between the lens (2) and the photovoltaic cell (15), and the fan means (16a) being situated between the photovoltaic cell (15) and the thermocouple(s) (7), wherein the rotation of the fan means (16a) serves to: (a) remove convective heat from the photovoltaic cell (15) by directing warm convective air from the photovoltaic cell out of the housing (20) via a vent (28) in a neck (25) of the housing, thereby increasing the efficiency of the photovoltaic cell; and (b) enhance the temperature differential across the thermocouple(s) (7), thereby increasing the efficiency of the thermocouple(s).

3. A converter according to claim 1 or claim 2, wherein the photovoltaic cell (15) has a concave surface, the centre of curvature of which lies at the focal point (3).

4. A converter according to claim 2 or claim 3, wherein the housing (20) is substantially spherical and transparent, and has at least one vent (20a, 20b) having a filter for ventillation of the housing and one or more spaces with air adjusting valves (21 a) and adjustable wall surfaces for promoting and aiding said rotation of the fan means (16a) caused by convection resulting from a temperature differential in the housing.

## Patentansprüche

1. Ein solarisch Energiekonverter hinein elektrische Energie wird charakterisieren: enthält wenigstens eine Konvexlinse (2) beritten in einer Behausung (20) für dem annehmen und konzentrieren die Solarstrahlen an einem Fokalpunkt (3) der Linse, wodurch die Linse aktiviert als ein Hitzekollektierend-Kondensator; und wenigtens (ein) Thermoelement(e) (7) deren höheren-febrile Fuge(n) (7a) wird(werden) am Fokalpunkt (3) der Linse (2) und aufwärts zur Linse (2) gestellen, in dem, ist in der Behausung ein Raumhalter (21) gegeben wird, das-(die) Thermoelement(e) (7) stützt(en) und dividierend die Behausung in Höher- und Nieder-Temperaturteilen um jedes(jeder) Thermoelements('elemente) verschaffen, der Raumhalter zwischen der Linse und dem(den) Thermoelement(e) (7) definierend den höher Temperature Teil des Apparates, dort das(der) Thermoelement(e) (7) funktionierend zu konvertieren manche Solarstrahlen in elektrische Energie; wenigstens ein Photoelektrizitätselement (15)(15a) gestellt gegen die Linse (2) in der Behausung zum Annehen des Sonnenlichts abweichend aus dem Fokalpunkt (3) und konvertierend das Sonnenlicht in elektrische Kraft, der Raumhalten zwischen dem Photoelektrizitätselement (15) und dem(den) Thermoelement(e) (7) definierend den Nieder-Temperatureteil des Apparates; ein Ventilator (16) gestalt damit er durch die steigende Luftkonvektion aus dem Photoelektrizitätselement (15) sowohl auch durch die vom Ventilator erhaltene direkt Radiation, der serviert für Resistenz gegen strahlende Wärme steigend vom Photoelektrizitätselement dabei assistierend, in Verbindung mit dem Raumhalter (21), die Erhaltung eines relativ grossen lemperaturunterschieds über die Seite des Thermoelements (7) gegenüber des Niedertemperaturteils zur Entfernung der Hitze und einen Temperaturunterschied über das Thermoelement (7); und ein elektromagnetische Generator (17), von der Rotation des Ventilators (16), zum Konvertieren eines Teils der Konvektiven Wärmenenergie in eslektrische Kraft, wobei die Linse, das Thermoelement, das Photoelektrizitätselement, und der Ventilator zusammenwirken damit die Solarenenergie in elektrische Kraft umso besser konvertiert wird.

2. Ein EnergieKonverter nach Anspsruch 1, dessen Linse (2) an der höchsten Stelle der Behausung sitzt, wobei das Photoelektrizitätselement (15) am niederen Ende der Behausung sich befindet, weit von der Solarenergiequelle, und das(die) Tharmoelement(e) (7) zwischen der Linse (2) und dem Photoelektrizitätselement (15) sitzt, und der Ventilator (16) zwischen dem Photoelektrizitätselement (15) und dem(den) Thermoelement(en) (7) sitzit, wobei die Rotation des Ventilators (16) folgendes verursacht:
( a ) die strahlende Wärme wird aus dem Photoelektrizitätselement (15) entfernt, dadurch, dass die warme konvektive Luft von dem Photoelektrizitätselement aus der Behausung (20) durch ein Ventil (28a) im Hals (25) der Behausung geführt wird, wobei das Nutzeffekt des Photoelektrizitätselements erhöht,
( b ) der Temperaturunterschied über dem-(den) Thermoelement(en) (7) wird erhöht, wobei der Nutzeffekt des(der) Thermoelementes(en) verbessert wird.

3. Ein Energiekonverter nach Anspruch 1 oder 2, wobei das Photoelektrizitätselement (15) eine konkave Fläche hat, deren Kurvenmitte am Fokalpunkt (3) liegt.

4. Ein Energiekonverter nach Anspruch 2 oder 3, wobei die Behausung wesentlich kugelförmig und durchsichtig, und mindestens einen Abfluss (20a, 20b) mit Filter zur Ventilation der Behausung und einen Raum order mehrere Räume mit luftkontrollierenden Ventilen (21a) und einstellbaren Wandflächen zum Nachhelfen der obenerwähnten Rotation des Ventilators (16), verursacht durch Konvektion, die ihrerseits durch den Temperatur unterschied in der Behausung verursacht wird.

## Revendications

1. Apareil de conversion de l'énergie sorlaire en énerrgie électrique caractériese en ce qu'il comprend: au moins lentille (2) contene dans le conteneur(20) pour réceptuer et focaliser le rayonsdu soleil au point foyer(3) la lentille, par lequel la lentille servir de un condenseur pour colection chaleur; et au mois un(une collection des) thermocouple(s)(7) dont la côté de la janction chaud(7a) positionne adjacent au foyer(3) de la lentille (2) et en la direction ascendant vers la lentille(2), caractériese en ce qu'il un support(21) existe en conteneur pour supportant le thermocouple(7) et divisant l'inte- reur du conteneur dans les chambres des températures réchaud et réfrais à chaque côté du thermocouple(s)(7), le support entre la lentille-(2) et le chaque côté du thermocouple(7) limite la région chaude de cet appareil, où le thermocouple(7) converse la énergie chaleur solaire et autres en énergie électrique; une celulle photoélectrique(15a,15), qu'existe autrement en conteneur de la lentille(2) pour récepteur la lumière du soleil divergent au foyer(3) et convertireur la énergiede la lumière soiaire en énergie électrique, à la region frais aussi du côté frais du thermocouple, où le espace entre la cellule photoélectrique(15) et le thermocouple(7) limite la région frais de cet appareil; un ventilateur(16) formant pour être activant à convection de air aussi arosant de la cellule photoélectrique(15) bien et direct radiation récepteur du ventilateur(16) que, lequel offrire pour resistannce contre chaleur de la convection venirant à la cellule photoélectrique, de cette manière assistant, et le support-(21), Le support(21) maintenirant une différence de temperature chaud relatifment en travers le(s) thermocouple(s), que l'air chaud se ca- nallse à travers le thermocouple pour renvoyer la chaleur de la région la plusfroide et aussi pour aider a maintenir cette différence de temperature dans le thermcouple; une générateur électromagnetique(17) activant par énergie de la rotation de le ventilateur(16) converseur en énergie de électrique; la lentille, le thermocouple, la cellule photoélectrique, et le ventillateur sont combinés de telle sorte quells conversion l'énergie solaire en énergie électrique.

2. Un convertisseur de énergie suivant la Revendication 1, la lentille(2) être situé à la portion plus hout de container, la cellule photoélectrique(15) être situé à la portion moins base que de container et retiré de la source chaude d'énergie solaire, le thermocouple(7) être situé entre la lentille(2) et la cellule photoélectrique(15), et le ventilateur-(16) être situé entre la cellule photoélectrique-(15) et le thermocouple(7), où la rotation du ventilateur(16) servir pour: A)- ôter chaleur de la convection de la cellule photoélectrique (15) dirigeant air chaud de la convection du conteneur(20) à air froid échangeant via un tube de vent(28a) de cou(25) de conteneur, par là augmentant l'efficacité de la cellule photoélectrique; et B)- rehausser différentiel de temperature en travers du(x) thermocouple(s)(7), par là augmentant l'efficacité de(s) thermocouple(s).

3. Un convertisseur de énergie suivant la Revendication 1 ou 2, en quoi une cellule photoélectrique(15) avoir une surface concave, de centre de la courbure quoi pose au foyer-(3).

4. Un convertisseur de énergie suivant la Revendication 2 ou 3, en quoi du conteneur(20) être substantielment spérique et transparent, et avoir au moins un orifice de vent(20a,20b) avoirant un filtre pour ventilation du conteneur et au moins un support(21) avoirant air valves-(21a) et surfaces du mur rêglable pour pro- mouvoirant et aideant la rotation susmentioné du ventilateur(16) causant à la convection ré- suitant à différentiel de la température du conteneur.
